# EUROPÄISCHE PATENTSCHRIFT

(11) **EP 0 969 982 B1**
(45) Veröffentlichungstag und Bekanntmachung des Hinweises auf die Patenterteilung: **12.09.2001**
(21) Anmeldenummer: 98922606.3
(22) Anmeldetag: 13.03.1998
(51) Int. Cl.: B60R 16/02, H05K 3/32, H05K 5/00

(54) **STEUERGERÄT FÜR EIN KRAFTFAHRZEUG**
CONTROL DEVICE FOR A VEHICLE
APPAREIL DE COMMANDE DESTINE A UN VEHICULE

(30) Priorität: 26.03.1997 DE 19712842
(43) Veröffentlichungstag der Anmeldung: 12.01.2000
(73) Patentinhaber: SIEMENS AKTIENGESELLSCHAFT, 80333 München (DE)
(72) Erfinder: SCHEUERER, Ulf, D-93047 Regensburg (DE); LOIBL, Josef, D-94209 Regen (DE); FRANZEN, Frank, D-93049 Regensburg (DE)
(86) Internationale Anmeldenummer: DE9800771
(87) Internationale Veröffentlichungsnummer: WO9842529

(56) Entgegenhaltungen:
- EP-A1- 0 519 202
- WO-A1-95/00363
- DE-A1- 2 841 443
- DE-A1- 4 102 265
- DE-U1- 29 501 849

## Beschreibung

Die Erfindung betrifft ein Steuergerät für ein Kraftfahrzeug gemäß dem Oberbegriff von Anspruch 1 sowie ein Verfahren zu dessen Herstellung.

Ein solches Steuergerät ist aus der Offenlegungsschrift DE 41 02 265 A1 bekannt. Dieses zeichnet sich durch ein einfach aufgebautes und kostengünstig herstellbares Gehäuse aus. Eine als Kühlkörper dienende Metallplatte ist gleichzeitig ein Teil des Gehäuses. Die Metallplatte weist lediglich auf einer Seite einen Anlagebereich mit weiteren Gehäusemitteln auf. Das Steuergerät ist über einen Stecker nach außen verbunden. Der Stecker muß zusätzlich auf die Metallplatte montiert werden, seine Anschlußpins müssen in einen Leiterbahnträger gesteckt und dort angelötet werden.

Das Gebrauchsmuster DE 295 01 849 U1 offenbart ein Kunststoffgehäuse, durch dessen Wände elektrische Zuleitungen geführt werden. Die Enden der Zuleitungen ragen frei in den Gehäuseinnenraum und sind dort in Löchern einer Leiterplatte eingepreßt, wodurch die Leiterplatte mechanisch gehalten und elektrisch kontaktiert wird.

Aus der Offenlegungsschrift DE 28 41 443 A1 ist eine Leiterplatte bekannt, die aus zwei dicken Lagen eines Basismaterials besteht. Die obere Lage trägt an der Unterseite eine Metallkaschierung. An Kontaktierungsstellen ist das Basismaterial ausgespart. Beim Bestücken der Leiterplatte mit Bauelementen werden die Anschlußdrähte in die Kontaktierungsstellen eingedrückt. Die Drähte durchdringen die Metallkaschierung und verkrallen sich dabei.

Es ist ein Ziel der Erfindung, ein Steuergerät bereitzustellen, bei dem eine auf einem Leiterbahnträger angebrachte elektronische Schaltung auf besonders einfache Weise mit elektrischen Anschlüssen verbunden wird.

Dieses Ziel wird mit einem Steuergerät und einem Verfahren erreicht, wie sie in den unabhängigen Ansprüchen definiert sind. Zweckmäßige Weiterbildungen der Erfindung sind in den Unteransprüchen angegeben.

In einer bevorzugten Ausführungsform stellen die aus dem Gehäusedeckel herausragenden und in die Bodenplatte oder Grundplatte hineinragenden elektrischen Leiter gleichzeitig eine mechanische Verbindung zwischen Gehäusedeckel und Bodenplatte und eine elektrische Verbindung zwischen der Gehäuseaußenseite und der elektronischen Schaltung her. Bereits das Aufsetzen des Gehäusedeckels auf die Bodenplatte bewirkt damit den Zusammenbau des Gehäuses und gleichzeitig eine elektrische Kontaktierung. Auf einen Lötvorgang kann hierbei verzichtet werden. Die auf diese Weise geschaffene elektrische Verbindung ist zuverlässig vor einem von Metallspänen verursachten Kurzschluß geschützt.

Zur Erhöhung der Sicherheit, oder wenn auf eine mechanische Verbindung mittels des Leiters verzichtet wird, kann eine Verbindung zwischen Bodenplatte und Gehäusedeckel, beispielsweise mittels Nieten, Schrauben oder Verpressen erfolgen.

Ein bevorzugtes Anwendungsgebiet der Erfindung ist die Integration einer Steuerelektronik in ein Automatikgetrieb zur Verwirklichung einer vollintegrierten Getriebesteuerung. Dabei wird die Steuerelektronik auf einer Schaltplatte angeordnet, die sich innerhalb der Ölwanne des Getriebes befindet.

Das Steuergerät eignet sich insbesondere für Systeme, bei denen Stanzgitter mit einer elektronischen Schaltung im Steuergerät verbunden werden müssen. Die Stanzgitter können dabei auch durch einfache Leitungsdrähte ersetzt werden.

Weitere Vorteile, Merkmale und Anwendungsmöglichkeiten der Erfindung ergeben sich aus der nachfolgenden Beschreibung der Ausführungsbeispiele in Verbindung mit den Zeichnungen. Es zeigt:
- Figur 1: einen Gehäusedeckel der auf eine Bodenplatte aufgesetzt wird;
- Figur 2: eine Draufsicht auf eine Bodenplatte, auf der eine flexible Folie angebracht ist;
- Figur 3a: ein aus einem Gehäusedeckel ragendes Drahtende vor dem Einpressen in eine Bohrung der Bodenplatte;
- Figur 3b: das Drahtende nach dem Einpressen in die Bohrung;
- Figur 4a bis d: vier verschiedene Ausgestaltungen einer Leiterbahn im Bereich einer Bohrung vor dem Einpressen eines Drahtendes oder Stanzgitters;
- Figur 5: ein Drahtende, dessen Stirnseite eine Leiterbahn kontaktiert;
- Figur 6: eine Detailansicht des in Figur 5 mit Z gekennzeichneten Bereichs;
- Figur 7: ein in einer Bodenplatte mittels Zähnen verankertes Drahtende;
- Figur 8: eine Detailansicht des in Figur 7 mit Z gekennzeichneten Bereichs;
- Figur 9: eine weitere Ausführungsform eines mittels Zähnen in einer Bodenplatte verankerten Drahtendes; und
- Figur 10: eine Detailansicht des in Figur 9 mit Z gekennzeichneten Bereichs.

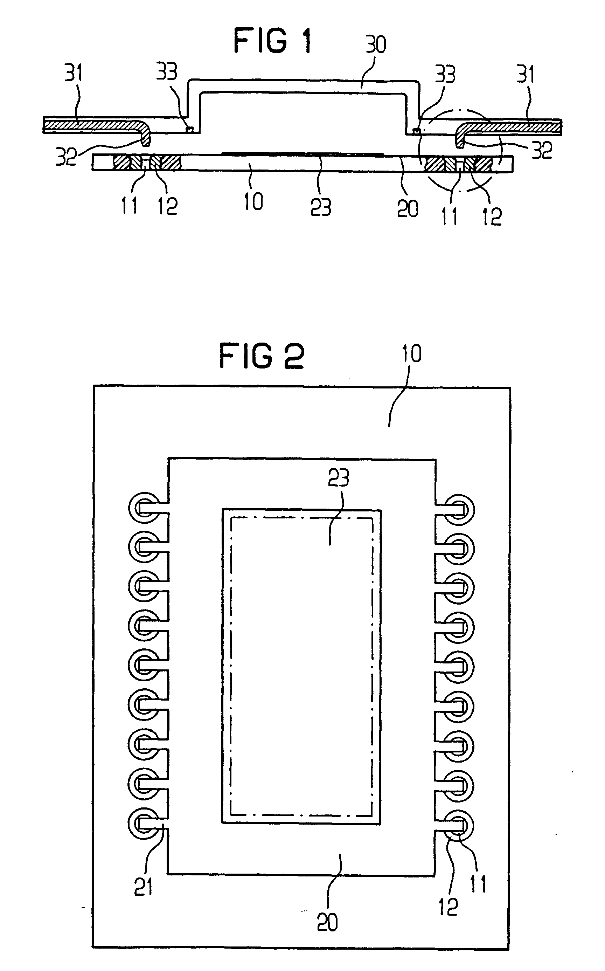

Figur 1 zeigt einen Gehäusedeckel 30 aus Kunststoff, der als Tragkörper für ein Steuergehäuse eines Automatikgetriebes ausgebildet ist. Ein derartiger Tragkörper ist auf einer Hydraulik-Schaltplatte befestigt und nimmt elektrische Leiter, Sensoren und einen Steckverbinder auf. Diese Komponenten liegen außerhalb des für eine Steuerelektronik oder elektronische Schaltung 23 gebildeten Hohlraums.

Beim Herstellen des Gehäusedeckels 30 und Tragkörpers werden die elektrischen Leiter entweder direkt in ein Spritzwerkzeug eingelegt, oder sie werden vorher, beispielsweise durch Anspritzen von Kunststoffstegen (Vorumspritzling), in ihrer Relativposition zueinander fixiert und anschließend im Spritzwerkzeug umspritzt.

Die Leiter sind als Leitungsdrähte 31 ausgebildet und mit Magnetspulen, einem Steckverbinder und Sensoren verbunden wie in der Patentschrift DE 43 44 584 C2 dargestellt. Die Leitungsdrähte 31 verlaufen im Gehäusedeckel von den erwähnten außenliegenden Komponenten, wie Steckverbinder, Sensoren und dergleichen, in Richtung einer elektronischen Schaltung 23. In einem Abschnitt außerhalb der elektronischen Schaltung ragen Drahtenden 32 aus dem Gehäusedeckel hervor. Eine umlaufende Dichtung 33 ist am Gehäusedeckel zur Abdichtung gegenüber einem Getriebeöl angebracht.

Eine metallische Bodenplatte 10 weist in einem Randbereich Öffnungen oder Bohrungen 11 auf. In die Bohrungen sind als Einpreßhülsen 12 ausgebildete Isolierhülsen eingebracht. Ein zentraler Bereich der Bodenplatte 10 ist von einem als flexible Polyimid-Folie 20 ausgebildeten Leiterbahnträger bedeckt.

Die flexible Folie 20 ist mit der elektronischen Schaltung 23 verbunden. Der Gehäuseinnenraum, in dem die elektronische Schaltung 23 untergebracht ist, wird im wesentlichen durch einen wannenförmigen Abschnitt des Gehäusedeckels 30 gebildet. Die Gehäusemittel sind allein der Gehäusedeckel (Tragkörper) und die Bodenplatte. Der Aufwand für das Gehäuse ist minimiert, da auf den ohnehin in einem Automatikgetriebe vorhandenen Tragkörper lediglich eine metallische Bodenplatte aufgesetzt wird, die gleichzeitig Kühlkörper für die elektronische Schaltung 23 ist.

Obgleich die zwischen Gehäusedeckel und Bodenplatte zur Anlage kommende Dichtung 33 in den Gehäusedeckel 30 integriert ist, kann sie auch auf der flexiblen Folie 20, beispielsweise durch Anspritzen, integriert sein. Die umlaufende Dichtung befindet sich weiter in Richtung des Gehäuseinnenraums als die Bohrungen 11 oder Öffnungen. Daher müssen die Bohrungen 11 und die im Gehäusedeckel 30 verlaufenden Leitungsdrähte 31 nicht gegen Öl abgedichtet sein, um die elektronische Schaltung 23 gegen eindringendes Öl zu schützen.

Aus Figur 2 ist erkennbar, daß Leiterbahnen 21 der flexiblen Folie 20 bis in den Bereich einer Bohrung 11 führen.

Die flexible Folie ist auf der metallischen Bodenplatte 10 ölfest auflaminiert. Hierzu wird eine Acryl-Kleber-Folie zwischen Bodenplatte und Polyimid-Folie eingefügt und unter Druck erhitzt, so daß eine Klebung zwischen Bodenplatte, Acryl und Polyimid erfolgt. Vorzugsweise ist die flexible Folie 20 bereits vor dem Aufbringen auf die Bodenplatte mit der Acryl-Kleber-Folie versehen.

Die elektronische Schaltung 23 ist vorzugsweise auf einem Keramik-Schaltungsträger aufgebracht. Für eine temperaturoptimierte Montage wird der Schaltungsträger mit der elektronischen Schaltung 23 auf eine nicht von der flexiblen Folie 20 bedeckte Fläche der metallischen Bodenplatte mit einem Wärmeleitkleber geklebt. Die gestrichelten Linien in Figur 2 deuten eine Erhebung der Bodenplatte an, an die die flexible Folie 20 angrenzt. In einer Überlappungszone ragt der Schaltungsträger über die Erhebung hinaus und ist dort mit einem elektrisch leitenden Kleber auf die Folie 20 geklebt, so daß eine elektrische Verbindung zwischen den Leiterbahnen 21 der flexiblen Folie 20 und der elektronischen Schaltung 23 entsteht.

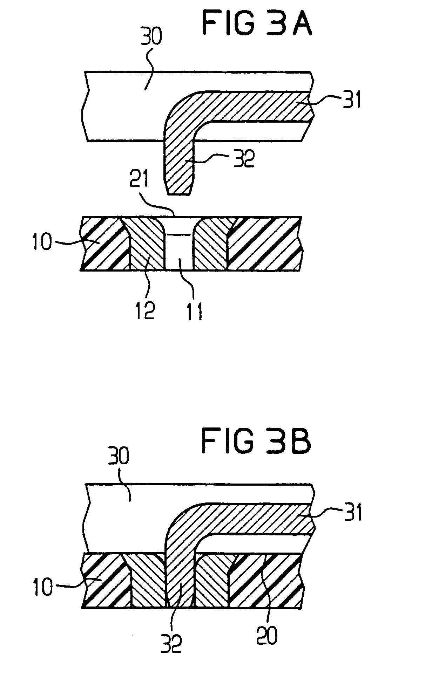

Das in Figur 3a gezeigte Drahtende 32 oder Anschlußende des Leitungsdrahts 31 ragt im wesentlichen rechtwinklig vom Gehäusedeckel ab in Richtung auf die Bodenplatte 10. Eine in eine Bohrung 11 eingesetzte elastische Einpreßhülse 12 aus Kunststoff weist einen Hinterschnitt auf, so daß sie beim Einpressen des Drahtendes 32 die auf sie ausgeübten Druckkräfte aufnehmen kann. Ein geeigneter Kunststoff für die Einpreßhülse 12 ist Polyamid. Zwischen der Öffnung der Einpreßhülse und einem Drahtende besteht eine negative Passung. Entsprechend dem Hinterschnitt der Einpreßhülse weist die Bohrung 11 auf der dem Gehäusedeckel 30 zugewandten Seite eine Senkung auf. Die Einpreßhülse ist in Richtung der vom Gehäusedeckel abgewandten Seite zum Schutz vor Getriebespäne geschlossen (nicht dargestellt). Die Einpreßhülse besteht aus elektrisch isolierendem Material.

In Figur 3b ist das Drahtende 31 in die Einpreßhülse 12 gesteckt. Beim Einsteckvorgang wird eine Leiterbahn 21 der flexiblen Folie 20 von dem Drahtende 31 in die Einpreßhülse 12 geschoben. Es besteht durch den reibschlüssigen Kontakt zwischen Einpreßhülse und dem Drahtende sowohl eine mechanische Klemmverbindung zwischen Gehäusedeckel 30 und Bodenplatte 10 als auch eine elektrische Verbindung zwischen dem Draht 31 und einer Leiterbahn 21 der flexiblen Folie 20. Somit ist eine elektrische Verbindung zwischen dem Draht 31 und der elektronischen Schaltung 23 hergestellt.

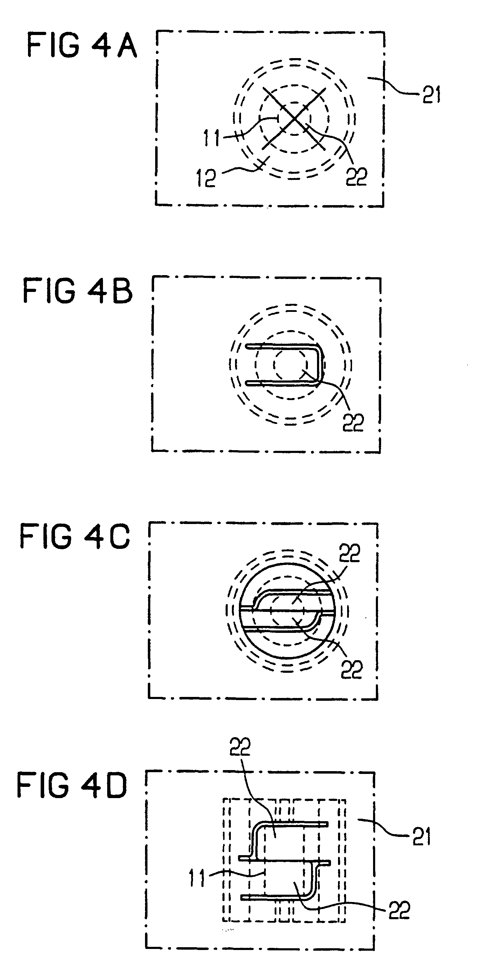

In Figur 4a überdeckt eine Leiterbahn 21 eine Einpreßhülse 12. Die gestrichelten Linien zeigen die verdeckten Kanten des Außenumfangs der Einpreßhülse 12, den Hinterschnitt der Einpreßhülse, eine in die Bohrung verlaufende Abflachung der Einpreßhülse und die Bohrung 11.

Im Bereich der Einpreßhülse ist die Leiterbahn 21 x-förmig geschlitzt. Dadurch bildet die Leiterbahn 21 vier Zungen 22 aus, die beim Einpressen eines Drahtendes 32 in die Einpreßhülse gezogen werden. Dadurch entsteht eine sehr feste und sichere elektrische und mechanische Verbindung, die auch den Umweltanforderungen in einem Getriebe hinsichtlich Öl, Vibration und Temperaturwechsel gewachsen ist.

In Figur 4b ist eine Bohrung 11 von einer einzigen länglichen Zunge 22 überdeckt.

In Figur 4c sind zwei flügelartige Zungen 22 gebildet, die beim Eindringen eines Drahtendes auseinander gedrückt werden.

In Figur 4d überdeckt die Leiterbahn 21 eine schlitzförmige Öffnung 11. Solche schlitzförmige Öffnungen sind zweckmäßig, wenn die vom Gehäusedeckel aufgenommenen elektrischen Leiter Stanzgitter sind. Es sind zwei in entgegengesetzte Richtungen zeigende Zungen 22 abgebildet, die jeweils in einem rechten Winkel zum Schlitz ausgerichtet sind.

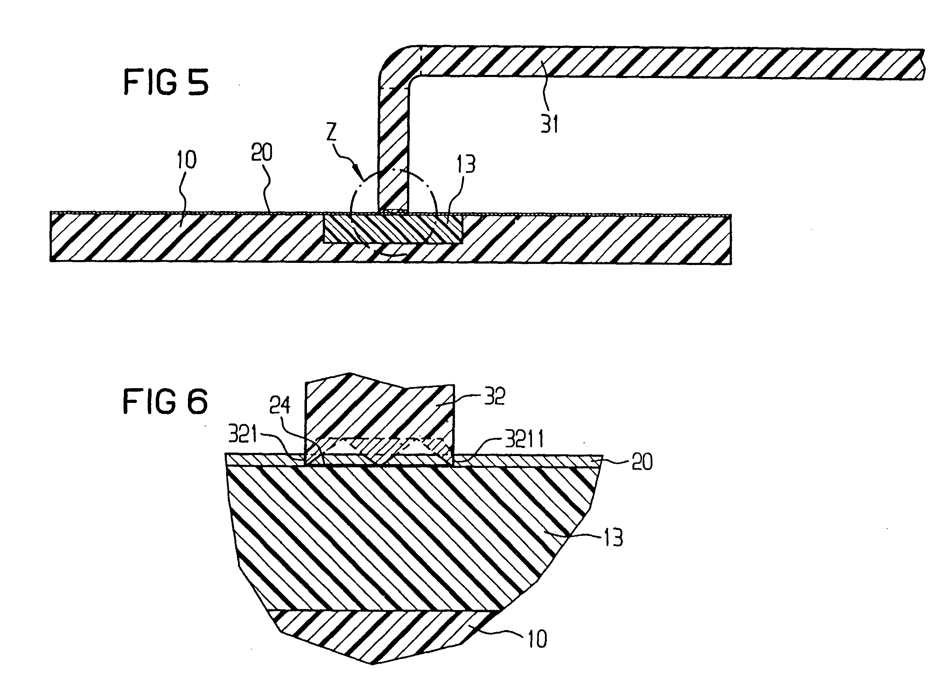

Figur 5 zeigt einen Kontakt zwischen einem Drahtende 32 und einer flexiblen Folie 20. Das Drahtende 32 drückt in axialer Richtung auf ein Kontaktpad einer Leiterbahn der flexiblen Folie. Zum Schutz vor einem Kurzschluß zwischen dem Drahtende 32 und einer metallischen Bodenplatte 10 ist im Kontaktbereich eine Isolierplatte 13 aus Kunststoff in die Bodenplatte 10 integriert. Dies verhindert einen elektrischen Kontakt des Drahtendes mit der metallischen Bodenplatte bei einer Beschädigung der flexiblen Folie.

Zur Herstellung eines elektrischen Kontakts zwischen den Leitungsdrähten 31 und der flexiblen Folie 20 und somit zu einer Steuerschaltung muß lediglich die Bodenplatte 10 mit dem Gehäusedeckel 30 mechanisch verbunden werden. Ein Bond- oder Lötprozeß ist nicht erforderlich. Auf die Darstellung des Gehäusedeckels 30, der den Leitungsdraht 31 aufnimmt, ist zugunsten einer besonders übersichtlichen Darstellung verzichtet.

In Figur 6 ist erkennbar, daß die einem Kontaktpad 24 der flexiblen Leiterbahnfolie 20 zugewandte Stirnseite 321 des Drahtendes 32 scharfe Vorsprünge 3211 oder Kanten aufweist, so daß sich das Drahtende 32 in die Oberfläche des Kontaktpads 24 eingräbt. Das Drahtende ragt aus dem Gehäusedeckel 30 hervor.

Um eine dauerhafte Kontaktierung des Drahtendes 32 mit der flexiblen Folie 20 sowohl bei Belastungen durch die Umgebung als auch bei Alterung zu gewährleisten, wird ein elastisches Element zur Erzeugung einer Federwirkung eingesetzt. Das elastische Element kann entweder ein freier, nicht vom Gehäuse umhüllter Teil des Leitungsdrahts 31 und/oder eine elastisch ausgebildete Isolierplatte 13 sein. Die elektrische Kontaktierung erfolgt durch Anpressen des Drahtendes 32 in axialer Richtung an ein Kontaktpad einer Leiterbahn. Die mechanische Fixierung von Bodenplatte 10 und Gehäusedeckel 30 wird getrennt von der elektrischen Kontaktierung beispielsweise durch Schrauben oder Niete erzielt.

Wird der Leitungsdraht 31 oder dessen Drahtende 32 elastisch ausgebildet, so wird Drahtende 32, das gegenüber der Anlagefläche des Gehäusedeckels 30 hervorsteht, beim Verbinden mit der Bodenplatte 10 und dem axialen Anpressen des Drahtes zurückgedrückt. Das Drahtende 32 übt folglich eine Druckspannung auf das Kontaktpad der nicht gezeigten Leiterbahn der flexiblen Folie 20 auf.

Zwischen der Bodenplatte 10 und dem Kontaktpad der Leiterbahn ist eine Kleberschicht aufgebracht. Die Basisfolie der flexiblen Folie 20 besteht aus Polyimid.

Eine von einer elastischen Isolierplatte 13 bereitgestellte Federwirkung läßt sich optimieren, wenn unter der Isolierplatte eine Ausnehmung in der Bodenplatte 10 eingebracht ist.

Die Oberseite der Isolierplatte 13 bildet eine Ebene mit der Bodenplatte 10, so daß die flexible Folie 20 eben aufgeklebt werden kann.

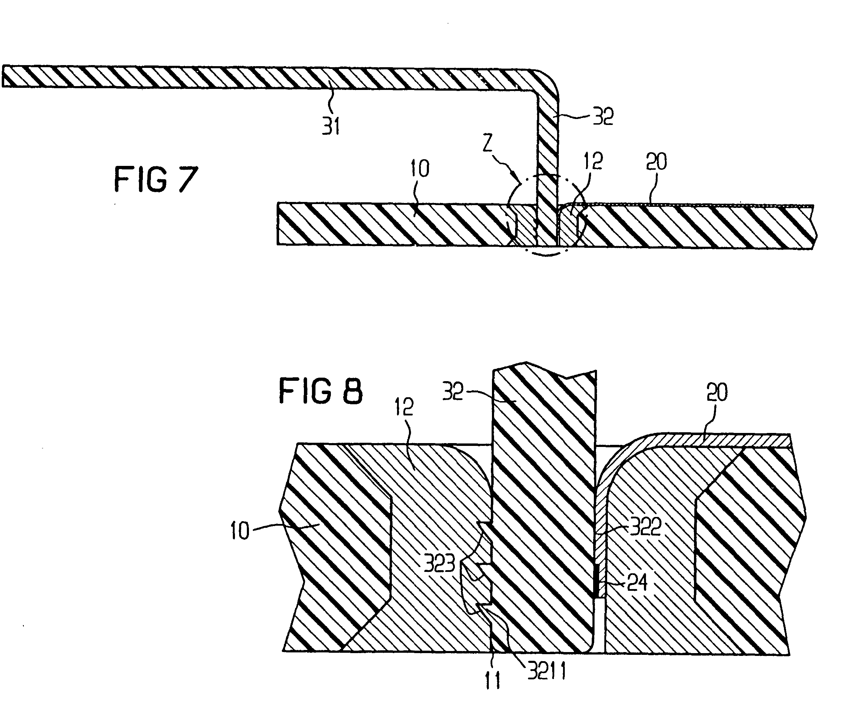

Figur 7 veranschaulicht eine gleichzeitige elektrische Kontaktierung und mechanische Fixierung mittels eines Endes eines Leiters oder Drahtendes 32. Das Drahtende hat einen glatt ausgebildeten Kontaktabschnitt 322 zu einer Leiterbahn der flexiblen Folie 20 und einen speziell ausgebildeten Eingriffsabschnitt 323 zu einer Bohrung 11 und genauer zu einer Einpreßhülse 12. Der Leiter oder Leitungsdraht 31 weist also einen separaten Eingriffsabschnitt für die mechanische Fixierung der Bodenplatte 10 an dem Gehäusedeckel 30 auf, der die elektrische Kontaktierung nicht beeinträchtigt.

Ein derart ausgebildetes Drahtende 32 kann für die in den Figuren 1 bis 4 dargestellten Geräten eingesetzt werden.

Aus Figur 8 wird deutlich, daß der Kontaktabschnitt 322 und der Eingriffsabschnitt 323 räumlich voneinander getrennt sind. Über einen Bereich des Umfangs des Drahtendes 32 ist in axialer Richtung der Kontaktbereich glatt zur Anlage an ein Kontaktpad 24 einer Leiterbahn der flexiblen Folie 20 ausgebildet. Die Einpreßhülse 12 hat wenigstens an der korrespondierenden Stelle ebenfalls eine glatte Oberfläche. Dadurch wird verhindert, daß das in die Bodenplatte oder Einpreßhülse einzupressende Drahtende 32 die zu kontaktierende Leiterbahn abschert. Die Stirnseite des Drahtendes sollte abgerundet oder halbkugelförmig gestaltet werden. Zusätzlich ist der Kontaktbereich der Leiterbahnfolie mit einem Gleitmittel beschichtet. Hierzu eignet sich beispielsweise Zinn.

In einem anderen Bereich des Umfangs ist das Drahtende 32 derart gestaltet, daß es beim Einpressen in die Bodenplatte 10 und speziell in die Einpreßhülse 12 aus Kunststoff eine deutliche Materialverdrängung und damit eine hohe mechanische Festigkeit der Fixierung bewirkt. In diesem Bereich des Umfangs sind in axialer Richtung Zähne oder Vorsprünge 3211 angeordnet. Diese bilden einen Abschnitt eines Rings. Die Vorsprünge 3211 gelangen beim Einpressen des Drahtendes 32 nicht in Kontakt mit der Leiterbahn, obwohl sie in axialer Richtung in der selben Höhe angeordnet sein oder sich überschneiden können.

Das Drahtende 32 weist über seine gesamte Länge einen im wesentlichen konstanten Durchmesser auf. Das als Steckstift ausgebildete Drahtende ist zur Bildung eines Vorsprungs 3211 bearbeitet, insbesondere geprägt.

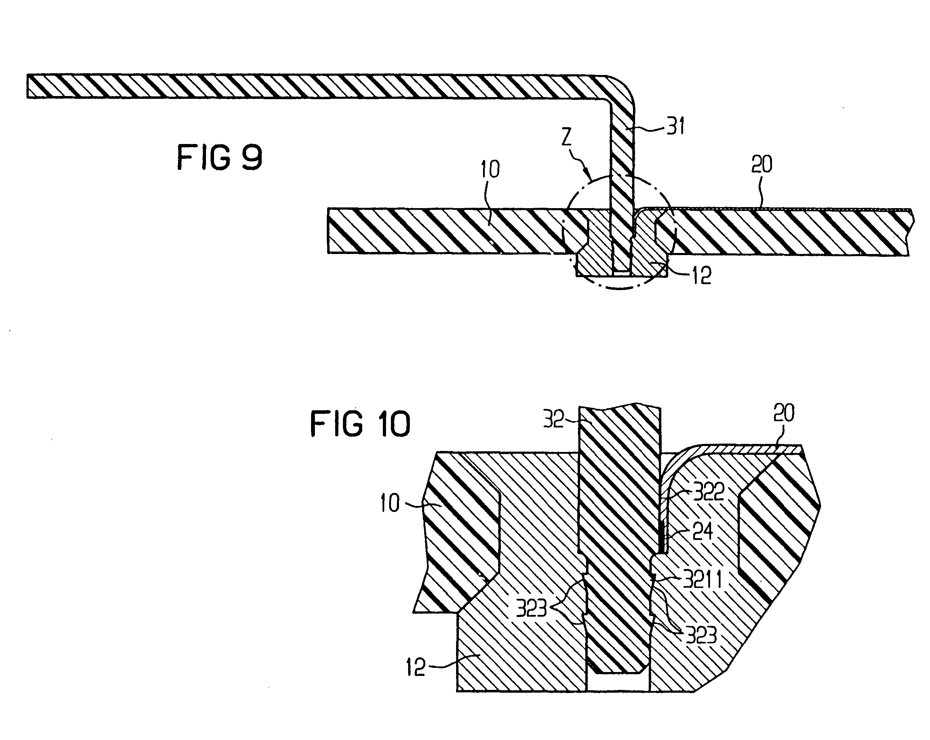

Das in Figur 9 dargestellte Drahtende 32 weist einen Eingriffsabschnitt 323 mit ringförmigen Vorsprüngen 3211 oder Zähnen auf, der in axialer Richtung in einer anderen Höhe als der Kontaktabschnitt 322 angeordnet ist. Die elektrische Kontaktierung erfolgt in einem Abschnitt des Drahtendes, der in Richtung der vom nicht dargestellten Gehäusedeckel abgedeckten Innenseite der Bodenplatte 10 zeigt. Darunter befindet sich der Eingriffsabschnitt 323.

Aus Figur 10 läßt sich erkennen, daß das Drahtende im Kontaktabschnitt 322 einen größeren Durchmesser als im Eingriffsbereich aufweist. Die Einpreßhülse 12 ist entsprechend im für die mechanische Fixierung bestimmten Bereich mit einer engeren Öffnung versehen. Das Drahtende 32 kann so beim Zusammenbau des Gehäuses die flexible Folie 20 mit einer Leiterbahn 21 in die Einpreßhülse 12 ziehen, übt aber keine merklichen Scherkräfte auf sie aus. Erst wenn der Kontaktabschnitt 322 in die Einpreßhülse eindringt wird eine Anpreßkraft auf die flexible Folie 20 und dem entsprechenden Kontaktpad 24 einer Leiterbahn ausgeübt.

Da bei einem Eingriff der Drahtenden 32 in die Bohrungen 11 oder Bond-, Schweiß-, Niet- oder Schraubprozesse entfallen können, ergeben sich bei derartigen Ausführungsformen große Einsparungen bei der Fertigung des Steuergeräts.

Bei einem Einsatz als vollständig in ein Getriebe integriertes Steuergerät ist kein zusätzlicher Spanschutz gegen elektrische Kurzschlüsse erforderlich. Gegenüber bisher bekannten öldichten Gehäusen werden Kontaktierfahnen oder Einpreßstifte zur Abdichtung des Gehäuses gegenüber dem Getriebeöl eingespart.

## Patentansprüche

1. Steuergerät für ein Kraftfahrzeug, das aufweist:
- eine Bodenplatte (10)
- einen auf der Bodenplatte angebrachten Leiterbahnträger (20),
- eine mit dem Leiterbahnträger (20) elektrisch verbundene elektronische Schaltung (23),
- einen mit der Bodenplatte (10) in einem Anlagebereich verbundenen Gehäusedeckel (30) aus Kunststoff,
**dadurch gekennzeichnet, daß**
- der Gehäusedeckel (30) elektrische Leiter (31) einhüllt und führt,
- ein Leiterende (32) eines elektrischen Leiters (31) aus dem Gehäusedeckel in Richtung der Bodenplatte (10) hervortritt und eine elektrische Verbindung mit einer Leiterbahn (21) des Leiterbahnträgers (20) herstellt.

2. Steuergerät nach Anspruch 1, **dadurch gekennzeichnet, daß** das Leiterende (32) mit seiner Stirnseite (321) eine elektrische Verbindung mit der Leiterbahn (21) in einem Bereich herstellt, in dem die Leiterbahn von der Bodenplatte (10) getragen ist.

3. Steuergerät nach dem vorhergehenden Anspruch, **dadurch gekennzeichnet, daß** das Leiterende (32) eine Stirnseite (321) und wenigstens einen Vorsprung (3211) aufweist.

4. Steuergerät nach Anspruch 1, **dadurch gekennzeichnet, daß** das Leiterende (32) in eine Öffnung (11) der Bodenplatte hineinragt und dort die Leiterbahn (21) kontaktiert.

5. Steuergerät nach dem vorhergehenden Anspruch, **dadurch gekennzeichnet, daß** Leiterenden (32) den Gehäusedeckel (30) an der Bodenplatte (10) reibschlüssig befestigen.

6. Steuergerät nach Anspruch 4 oder 5, **dadurch gekennzeichnet, daß** die Öffnung (11) in der Bodenplatte (10) eine Isolierbuchse (12) aufweist.

7. Steuergerät nach einem der Ansprüche 4 bis 6, **dadurch gekennzeichnet, daß** das Leiterende (32) einen Kontaktabschnitt (322) zum elektrischen Kontaktieren der Leiterbahn (21) des Leiterbahnträgers (20) und einen Eingriffsabschnitt (323) zum mechanischen Fixieren der Bodenplatte (10) oder der Isolierbuchse (12) aufweist.

8. Steuergerät nach einem der vorhergehenden Ansprüche, **dadurch gekennzeichnet, daß** der Leiterbahnträger (20) eine flexible Folie ist.

9. Steuergerät nach einem der vorhergehenden Ansprüche, **dadurch gekennzeichnet, daß** die Leiterenden (32) in dem Anlagebereich zwischen Bodenplatte (10) und Gehäusedeckel (30) aus letzterem hervortreten.

10. Steuergerät nach einem der vorhergehenden Ansprüche, **dadurch gekennzeichnet, daß** der Gehäusedeckel (30) ein tragendes Teil eines Gehäuses eines Steuergeräts ist, das in einem Motorraum eines Kraftfahrzeugs oder in einem Automatikgetriebe im Öl angeordnet ist.

11. Steuergerät nach einem der vorhergehenden Ansprüche, **gekennzeichnet durch** eine umlaufende Dichtung (33) zwischen der Bodenplatte (10) und dem Gehäusedeckel (30).

12. Verfahren zum Herstellen eines Steuergeräts, das ein Gehäuse und eine elektronischen Schaltung aufweist, mit den Schritten:
- ein Leiterbahnträger (20) wird auf eine Bodenplatte (10) aufgebracht,
- der Leiterbahnträger (20) wird mit einer elektronischen Schaltung (23) verbunden,
- ein Gehäusedeckel (30) aus Kunststoff mit darin eingefaßten elektrischen Leitern (31) wird so gebildet, daß die Leiterenden (32) der elektrischen Leiter aus dem Gehäusedeckel ragen,
- der Gehäusedeckel (30) und die Bodenplatte (10) werden zusammengesetzt, so daß die Leiterenden (32) in die öffnungen (11) der Bodenplatte (10) ragen und einen elektrischen Kontakt mit den Leiterbahnen (21) des Leiterbahnträgers (20) herstellen.

13. Verfahren nach dem vorhergehenden Anspruch, **dadurch gekennzeichnet, daß** die Bodenplatte (10) Öffnungen (11) aufweist, daß der Leiterbahnträger (20) so auf die Bodenplatte (10 aufgebracht wird, daß Leiterbahnen (21) des Leiterbahnträgers sich in der. Bereich der Öffnungen (11) erstrecken, und daß beim Zusammensetzen der Bodenplatte (10) und des Gehausedechels (30) die Leiterenden (32) in die Öffnungen (11) der Bodenplatte (10) gesteckt werden und dort einen elektrischen Kontakt mit den Leiterbahnen (21) herstellen.

14. Verfahren nach dem vorhergehenden Anspruch, **dadurch gekennzeichnet, daß** eine Leiterbahn (21) des Leiterbahnträgers (20) eine Öffnung (11) der Bodenplatte (10) bedeckt, und daß im Bereich der Öffnung (11) wenigstens eine Zunge (22) in die Leiterbahn eingebracht wird, die spätestens beim Eindringen eines Leiterendes (32) in die Öffnung (11) umgebogen wird und einen elektrischen Kontakt mit dem elektrischen Leiter (31) herstellt.

15. Verfahren nach Anspruch 13 oder 14, **dadurch gekennzeichnet, daß** die Leiterenden (32) sowohl einen elektrischen Kontakt mit den Leiterbahnen (21) als auch die einzige mechanische Verbindung zwischen dem Gehäusedeckel (30) und der Bodenplatte (10) herstellen.

## Claims

1. Controller for a motor vehicle, which has:
- a baseplate (10)
- a conductor track substrate (20) fitted on the baseplate,
- an electronic circuit (23) which is electrically connected to the conductor track substrate (20),
- a housing cover (30) which is connected to the baseplate (10) in a contact region and is made of plastic,
**characterized in that**
- the housing cover (30) encases and guides electrical conductors (31),
- one conductor end (32) of an electrical conductor (31) projects out of the housing cover in the direction of the baseplate (10) and produces an electrical connection to a conductor track (21) on the conductor track substrate (20).

2. Controller according to Claim 1, **characterized in that** the end face (321) of the conductor end (32) produces an electrical connection to the conductor track (21) in a region in which the conductor track is supported by the baseplate (10).

3. Controller according to the preceding claim,
**characterized in that** the conductor end (32) has an end face (321) and at least one projection (3211).

4. Controller according to Claim 1, **characterized in that** the conductor end (32) projects into an opening (11) in the baseplate, and makes contact with the conductor track (21) there.

5. Controller according to the preceding claim,
**characterized in that** the conductor ends (32) attach the housing cover (30) to the baseplate (10) by friction.

6. Controller according to Claim 4 or 5,
**characterized in that** the opening (11) in the baseplate (10) has an insulating bush (12).

7. Controller according to one of Claims 4 to 6,
**characterized in that** the conductor end (32) has a contact section (322) for making electrical contact with the conductor track (21) on the conductor track substrate (20), and has an engagement section (323) for mechanically fixing the baseplate (10) or the insulating bush (12).

8. Controller according to one of the preceding claims, **characterized in that** the conductor track substrate (20) is a flexible film.

9. Controller according to one of the preceding claims, **characterized in that** the conductor ends (32) project out of the housing cover (30) in the contact region between the baseplate (10) and the housing cover (30).

10. Controller according to one of the preceding claims, **characterized in that** the housing cover (30) is a load-bearing part of a housing of a controller, which is arranged in an engine compartment of a motor vehicle or in the oil in an automatic transmission.

11. Controller according to one of the preceding claims, **characterized by** a circumferential seal (33) between the baseplate (10) and the housing cover (30).

12. Method for producing a controller, which has a housing and an electronic circuit, with the steps:
- a conductor track substrate (20) is applied to a baseplate (10),
- the conductor track substrate (20) is connected to an electronic circuit (23),
- a housing cover (30) made of plastic and having electrical conductors (31) held in it is formed such that the conductor ends (32) of the electrical conductors project out of the housing cover,
- the housing cover (30) and the baseplate (10) are assembled such that the conductor ends (32) project into the openings (11) in the baseplate (10) and produce an electrical contact with the conductor tracks (21) on the conductor track substrate (20).

13. Method according to the preceding claim,
**characterized in that** the baseplate (10) has openings (11), in that the conductor track substrate (20) is applied to the baseplate (10) such that the conductor tracks (21) on the conductor track substrate extend into the region of the openings (11), and in that, during assembly of the baseplate (10) and of the housing cover (30), the conductor ends (32) are inserted into the openings (11) in the baseplate (10) and produce an electrical contact with the conductor tracks (21) there.

14. Method according to the preceding claim,
**characterized in that** one conductor track (21) on the conductor track substrate (20) covers an opening (11) in the baseplate (10), and in that at least one tongue (22) is incorporated in the conductor track in the region of the opening (11), is bent into the opening (11) at the latest when a conductor end (32) is being inserted, and produces an electrical contact with the electrical. conductor (31).

15. Method according to Claim 13 or 14, **characterized in that** the conductor ends (32) produce not only an electrical contact with the conductor tracks (21) but also the only mechanical connection between the housing cover (30) and the baseplate (10) .

## Revendications

1. Appareil de commande pour un véhicule automobile qui présente:
- une plaque de fond (10)
- un support de pistes conductrices (20) monté sur la plaque de fond,
- un circuit électronique (23) connecté électriquement au support de pistes conductrices (20)
- un couvercle de boîtier (30) en matière plastique assemblé à la plaque de fond (10) dans une région d'appui,
**caractérisé en ce que**
- le couvercle de boîtier (30) renferme et guide des conducteurs électriques (31),
- une extrémité (32) d'un conducteur électrique (31) émerge du couvercle de boîtier en direction de la plaque de fond (10) et établit une liaison électrique avec une piste conductrice (21) du support de pistes conductrices (20).

2. Appareil de commande selon la revendication 1,
**caractérisé en ce que** l'extrémité de conducteur (32) établit par son côté frontal (321) une liaison électrique avec la piste conductrice (21) dans une région dans laquelle la piste conductrice est portée par la plaque de fond (10).

3. Appareil de commande selon la revendication précédente, **caractérisé en ce que** l'extrémité de conducteur (32) présente un côté frontal (321) et au moins une saillie (3211).

4. Appareil de commande selon la revendication 1,
**caractérisé en ce que** l'extrémité de conducteur (32) est engagée dans une ouverture (11) de la plaque de fond et, là, entre en contact avec la piste conductrice (21).

5. Appareil de commande selon la revendication précédente, **caractérisé en ce que** les extrémités de conducteurs (32) fixent le couvercle de boîtier (30) à la plaque de fond (10) par une liaison par friction.

6. Appareil de commande selon la revendication 4 ou 5, **caractérisé en ce que** l'ouverture (11) ménagée dans la plaque de fond (10) présente une douille isolante (12).

7. Appareil de commande selon l'une des revendications 4 à 6, **caractérisé en ce que** l'extrémité de conducteur (32) présente un segment de contact (322) destiné à établir le contact électrique avec la piste conductrice (21) du support de pistes conductrices (20) et un segment de prise (323) destiné à la fixation mécanique de la plaque de fond (10) ou de la douille isolante (12).

8. Appareil de commande selon l'une des revendications précédentes, **caractérisé en ce que** le support de pistes conductrices (20) est une feuille flexible.

9. Appareil de commande selon l'une des revendications précédentes, **caractérisé en ce que**, dans la région d'appui entre la plaque de fond (10) et le couvercle de boîtier (30), les extrémités de conducteurs (32) émergent de ce couvercle.

10. Appareil de commande selon l'une des revendications précédentes, **caractérisé en ce que** le couvercle de boîtier (30) est une partie porteuse d'un boîtier d'un appareil de commande qui est disposé dans l'huile, dans un compartiment de moteur de véhicule automobile ou dans une boîte de vitesses automatique.

11. Appareil de commande selon l'une des revendications précédentes, **caractérisé par** une garniture d'étanchéité périphérique (33) entre la plaque de fond (10) et le couvercle de boîtier (30).

12. Procédé de fabrication d'un appareil de commande qui présente un boîtier et un circuit électronique, comprenant les étapes suivantes :
- un support de pistes conductrices (20) est placé sur une plaque de fond (10) ,
- le support de pistes conductrices (20) est connecté à un circuit électronique (23),
- un couvercle de boîtier (30) en matière plastique possédant des conducteurs électriques (31) logés dans ce couvercle est formé de telle manière que les extrémités (32) des conducteurs électriques émergent du couvercle du boîtier,
- le couvercle de boîtier (30) et la plaque de fond (10) sont assemblés de telle manière que les extrémités de conducteurs (32) soient engagées dans les ouvertures (11) de la plaque de fond (10) et établissent un contact électrique avec les pistes conductrices (21) du support de pistes conductrices (20).

13. Procédé selon la revendication précédente,
**caractérisé en ce que** la plaque de fond (10) présente des ouvertures (11), en ce que le support de piste conductrice (20) est posé sur la plaque de fond (10) de telle manière que les pistes conductrices (21) du support de pistes conductrices se prolongent dans la région des ouvertures (11) et en ce que, lors de l'assemblage de la plaque de fond (10) et du couvercle de boîtier (30), les extrémités de conducteurs (32) soient emmanchées dans les ouvertures (11) de la plaque de fond (10) et, là, établissent un contact électrique avec les pistes conductrices (21).

14. Procédé selon la revendication précédente,
**caractérisé en ce qu'**une piste conductrice (21) du support de pistes conductrices (20) recouvre une ouverture (11) de la plaque de fond (10) et en ce que, dans la région de l'ouverture (11), au moins une languette (22) est formée dans la piste conductrice, qui au plus tard lors de l'enfoncement d'une extrémité conductrice (32) dans l'ouverture (11) est repliée dans l'ouverture (11) et établit un contact électrique avec le conducteur électrique (31).

15. Procédé selon la revendication 13 ou 14,
**caractérisé en ce que** les extrémités de conducteurs (32) établissent aussi bien un contact électrique avec les pistes conductrices (21) que l'unique liaison mécanique entre le couvercle de boîtier (30) et la plaque de fond (10) .
